# EUROPEAN PATENT APPLICATION

(11) **EP 4 279 451 A1**
(43) Date of publication of application: **22.11.2023**
(21) Application number: 22173970.9
(22) Date of filing: 18.05.2022
(51) Int. Cl.: C01B 32/963, C01B 32/977, C23C 16/32

(54) **METHOD FOR PRODUCING AT LEAST ONE CRACK-FREE SIC PIECE**

(71) Applicant: Zadient Technologies SAS, 73800 Sainte-Hélène-du-Lac (FR)
(72) Inventor: Ceran, Kagan, 73190 Saint Baldoph (FR); Schaaf, Friedrich, 06116 Halle (DE)
(74) Representative: Kehl, Ascherl, Liebhoff & Ettmayr Patentanwälte Partnerschaft mbB

(57) **Abstract**

The present invention refers to a method for producing at least one crack-free SiC piece at least comprising the steps:
Providing a CVD reactor, wherein the CVD reactor comprises at least one SiC growth substrate, wherein the at least one SiC growth substrate comprises a main body, a first power connection and a second power connection, wherein the main body has a main body length, wherein the main body length extends between the first power connection and the second power connection, wherein the first power connection is configured to conduct power into the main body for heating the main body and wherein the second power connection is configured to conduct electric power conducted via the first power connection into the main body out of the main body, wherein the main body forms a physical structure, wherein the physical structure forms a deposition surface for deposition of SiC, Growing a SiC solid by depositing SiC on the physical structure in the CVD reactor, wherein the at least one crack-free SiC piece is part of the SiC solid, wherein the deposited SiC has a minimal thickness of at least 1cm, wherein the at least one SiC piece is formed between a first plane and a second plane, wherein the first plane is perpendicular to the main body length and wherein the second plane is perpendicular to the main body length, wherein the distance between the first plane and the second plane is at least 1% of the main body length, Removing the at least one crack-free SiC piece from the SiC solid, wherein the at least one crack-free SiC piece has a cross-sectional size of at least 4cm2 and a thickness of at least 0,1cm.

## Description

The present invention refers according to claim 1 to a method for producing at least one crack-free SiC piece, according to claim 9 to a method for the production of multiple crack-free workpieces, according to claim 11 to a method for the production of a composite substrate, according to claim 12 to a carrier wafer, according to claim 13 to a crack-free SiC piece, according to claim 14 to a method for producing predefined PVT source material pieces for filling a source material receiving space of PVT reactor and according to claim 15 to a method for producing SiC material.

SiC pieces can be used in different applications, in particular as braking wheels or PVT source material or carrier wafers. However, carrier wafer are produced according to the state of the art by depositing a thin layer on a substrate in a CVD process. Said process is very slow and therefore expensive.

Therefore, it is the object of the present invention to provide a method allowing cheaper production of SiC for use as SiC piece.

The before mentioned object is solved by a method according to claim 1 for producing at least one crack-free SiC piece. Said method preferably comprises at least the steps: Providing a CVD reactor, wherein the CVD reactor comprises at least one SiC growth substrate, wherein the at least one SiC growth substrate comprises a main body, a first power connection and a second power connection, wherein the main body has a main body length, wherein the main body length extends between the first power connection and the second power connection, wherein the first power connection is configured to conduct power into the main body for heating the main body and wherein the second power connection is configured to conduct electric power conducted via the first power connection into the main body out of the main body, wherein the main body forms a physical structure, wherein the physical structure forms a deposition surface for deposition of SiC. The method preferably also comprises the step of growing a SiC solid by depositing SiC on the physical structure in the CVD reactor, wherein the at least one crack-free SiC piece is part of the SiC solid, wherein the deposited SiC has a minimal thickness of at least 1cm, wherein the at least one SiC piece is formed between a first plane and a second plane, wherein the first plane is perpendicular to the main body length and wherein the second plane is perpendicular to the main body length, wherein the distance between the first plane and the second plane is at least 1% and preferably at least 2% and highly preferably at least 5% of the main body length. The preferably also comprises the step of removing the at least one crack-free SiC piece from the SiC solid, wherein the at least one crack-free SiC piece has a cross-sectional size of at least 4cm² and preferably of at least 8cm² and highly preferably of at least 12cm² and a thickness of at least 0,1cm and preferably of at least 1cm and highly preferably of at least 2cm.

This solution is beneficial since crack-free SiC is produced which allows the production of SiC solids which can be used for different applications, in particular applications having high mechanical, thermal and/or electrical load.

The mentioned CVD reactor can be modification of a CVD reactor according to PCT/EP2021/085479. The subject-matter of PCT/EP2021/085479 is entirely incorporated into the present subject-matter by reference.

Removing can be carried out by means of different technologies, e.g. according to WO2021191511, WO2016162428 or US2014038392.

Further preferred embodiments are subject-matter of the following specification parts and/or the dependent claims.

The volume of the at least one crack-free SiC piece is according to a preferred embodiment of the present invention more than 2cm³ and preferably more than 4cm³ and most preferably more than 8cm³. This embodiment is beneficial since large crack-free volumetric bodies allow the production of large SiC solids, in particular large carrier wafer.

The at least one crack-free SiC piece extends according to a preferred embodiment of the present invention in a first direction more compared to a second direction, wherein the second direction is orthogonal to the first direction. This embodiment is beneficial since the SiC piece can be a defined block of SiC, in particular for usage as PVT source material.

The first direction is according to a preferred embodiment of the present invention parallel to the main body length or coaxial to the main body length or aligned in an angle of less than 50°, in particular of less than 30° and preferably of less than 10° and most preferably of less than 5° or of 0°, with respect to the main body length. The first direction is preferably aligned in an angle between 120° and 60°, in particular in an angle between 110° and 70° and preferably in an angle between 100° and 80° and most preferably in an angle between 95° and 85° or in an angle of 90°, with respect to the main body length. This embodiment is beneficial since the SiC solid can be aligned in an angle different to 0° or 90° with respect to the length direction.

The at least one crack-free SiC piece is according to a preferred embodiment of the present invention formed in a distance to the physical structure. This embodiment is beneficial since the physical structure can be reused since the crack-free SiC piece could be removed from the grown crust.

The physical structure comprises according to a preferred embodiment of the present invention less than 5% (mass) SiC and preferably less than 2% (mass) SiC and highly preferably less than 1% (mass)SiC. This embodiment is beneficial since the physical structure can be made of a material mainly (mass) or entirely (mass) different from SiC.

The physical structure comprises according to a preferred embodiment of the present invention more than 90% (mass) of graphite, tungsten or a carbon-fiber-composite (CFC) material and preferably more than 95% (mass) of graphite, tungsten or a carbon-fiber-composite (CFC) material and highly preferably more than 99% (mass) of graphite, tungsten or a carbon-fiber-composite (CFC) material and most preferably more than 99,9% (mass) of graphite, tungsten or a carbon-fiber-composite (CFC) material. This embodiment is beneficial since a physical structure made of graphite, tungsten or carbon-fiber composite (CFC) material can be reused and can be easily manufactured.

The at least one crack-free SiC piece is according to a preferred embodiment of the present invention formed at least partially as part of the physical structure. This embodiment is beneficial since the crack-free SiC piece can be significant larger compared to SiC pieces only removed from the crust.

The physical structure comprises according to a preferred embodiment of the present invention more than 90% (mass) and preferably more than 95% (mass) and particular preferably more than 99% (mass) and most preferably more than 99,99% SiC, in particular polycrystalline SiC, in particular of a 3C crystal structure. The deposited SiC is according to a preferred embodiment of the present invention polycrystalline SiC, wherein the deposited SiC forms volume sections with different crystal structures, wherein a 3C crystal structure is predominantly (mass and/or volume) formed. The volume and/or mass of SiC formed in the 3C crystal structure comprises according to a preferred embodiment of the present invention more than 50% (volume and/or mass) and preferably more than 90% (volume and/or mass) and particular preferably more than 99% (volume and/or mass) and most preferably more than 99,9% (volume and/or mass) of the deposited SiC. This embodiment is beneficial since the crust and the physical structure are preferably having the same crystal structure or mainly the same crystal structure or at least a similar crystal structure, therefore SiC pieces consisting of parts of the physical structure and the crust are having very uniform mechanical, electrical and/or chemical properties, which allows usage in a large range of applications. Uniform mechanical, electrical and/or chemical properties have to be understood as differing preferably less than 10% and particular preferably less than 5% and most preferably less than 1%.

The method comprises according to a preferred embodiment of the present invention the step of controlling cooling of the deposited SiC and the physical structure. Current flow through the physical structure is according to a preferred embodiment of the present invention reduced in a defined manner, in particular over a defined time, in particular of more than 1h or preferably of more than 2h or particular preferably of more than 3h or most preferably of more than 4h. This embodiment is beneficial since due to a controlled cooling tensions resulting from thermal differences can be limited respectively reduced. The reduction of thermal induced tensions reduces the generation and/or propagation of cracks.

The deposited SiC comprises according to a preferred embodiment of the present invention less than 2000ppba nitrogen, in particular less than 100ppba nitrogen. This embodiment is beneficial since the deposited SiC respectively the SiC pieces can be used in a PVT reactor as source material without contaminating the monocrystalline SiC with nitrogen in case nitrogen is not desired.

The method comprises according to a preferred embodiment of the present invention the step of feeding nitrogen into the CVD reactor for doping the SiC during depositing. This embodiment is beneficial since SiC pieces can be manufactured with defined electrical properties for use e.g. as carrier wafer.

The deposited SiC and/or the physical structure has according to a preferred embodiment of the present invention impurities of less than 10ppm (weight) of the substance N and of less than 1000 ppb (weight), in particular of less than 500 ppb (weight), of each of the substances B, Al, P, Ti, V, Fe, Ni. The deposited SiC and/or the physical structure has preferably impurities of less than 2ppm (weight) of the substance N and of less than 100 ppb (weight) of each of the substances B, Al, P, Ti, V, Fe, Ni. The deposited SiC and/or the physical structure has highly preferably impurities of less than 10 ppb (weight) of the substance Ti. The deposited SiC and/or the physical structure has most preferably impurities of less than 10ppm (weight) of the substance N and of less than 1000 ppb (weight), in particular of less than 500 ppb (weight), of the sum of all of the metals Ti, V, Fe, Ni. This embodiment is beneficial the SiC piece or multiple SiC pieces can be used as high-quality PVT source material for the production of monocrystalline SiC crystals having a very small amount of one or multiple of the substances B, Al, P, Ti, V, Fe, Ni.

The above-mentioned object is also solved according to claim 9 by a method for the production of multiple crack-free workpieces. Said method preferably comprises at least a method according to any of claims 1 to 8, and the step of dividing the at least one crack-free SiC piece in multiple predetermined pieces. This solution is beneficial since multiple carrier wafer, in particular two or more than two and preferably five or more than five and particular preferably ten or more than ten or up to 50, can be removed from one SiC piece. Since removing of carrier wafers is much faster compared to growing each single polycrystalline SiC wafer in a CVD process the costs can be significantly reduced by means of the present invention.

The dividing step comprises according to a preferred embodiment of the present invention cutting the defined volume section with at least one wire saw or weakening the structure of the defined volume with laser radiation and thereby generating a defined laser-split-plane and introducing an external force to propagate a crack along the defined laser-split-plane or implanting ions into the structure of the defined volume and thereby generating a defined ion-split-plane and increasing the pressure inside the defined volume by increasing the volume of the implanted ions, in particular by heating the defined volume, to propagate a crack along the defined ion-split-plane. This embodiment is beneficial since different dividing methods can be applied. Thus, in dependency of the required properties a matching dividing method can be selected. E.g. in case the contamination should be very small, a defined laser-split-plane could be used. In case the costs should be as small as possible a wire saw could be used.

Thus, dividing can be carried out by means of different technologies, e.g. according to WO2021191511, WO2016162428 or US2014038392.

The predetermined pieces are according to a preferred embodiment of the present invention wafers, wherein each wafer has a height of more than 200µm, in particular of more than 250µm and preferably of up to 1000µm or of more than 1000µm. This embodiment is beneficial since the generated wafers have a high mechanical strength and could therefore be used as carrier wafer for carrying very small monocrystalline wafers, in particular very small monocrystalline SiC wafers. Very small preferably defines a thickness of less than 100 µm and preferably of less than 50 µm and most preferably of less than 40 µm.

A diameter of the main body has according to a preferred embodiment of the present invention a minimum length of 100mm and preferably a minimum length of 150mm and particular preferably a minimum length of 250mm and most preferably a minimum or maximum length of 300mm. This embodiment is beneficial since large SiC pieces can be generated.

The above-mentioned object is also solved according to claim 11 by a method for the production of a composite substrate. The method preferably comprises at least a method according to claim 10 and the steps: Processing at least one surface of the wafer, in particular grinding and/or lapping and/or polishing, to generate a processed surface having at least one defined surface property and bonding a monocrystalline SiC wafer to the processed surface. This solution is beneficial since the composite substrate can be produced at low cost, since the costs for the production of the carrier wafer are significantly reduces.

According to a preferred embodiment of the present invention each SiC growth substrate comprises a first power connection and a second power connection, wherein the first power connections are first metal electrodes and wherein the second power connections are second metal electrodes, wherein the first metal electrodes and the second metal electrodes are preferably shielded from a reaction space inside the process chamber, wherein each SiC growth substrate is coupled between at least one first metal electrode and at least one second metal electrode for heating the outer surface of the SiC growth substrates or the surface of the deposited SiC to temperatures between 1300°C and 1800°C, in particular by means of resistive heating and preferably by internal resistive heating. This embodiment is beneficial since the SiC growth substrates can be heated in a very effective manner.

Since flowing electrical current requires an inlet and an outlet electrode, these electrodes are preferably disposed in multiple pairs, such as preferably 12 pairs or 18 pairs or 24 pairs or 36 pairs or more. A deposition substrate respectively SiC growth substrate is preferably attached to each electrode, in particular metal electrode, of an electrode pair (first and second metal electrode) and the substrates are connected at the top by a cross member respectively bridge of the same material as the substrate to complete the electrical circuit. The deposition substrates respectively SiC growth substrates are preferably attached to the electrodes via an intermediate piece respectively chuck. The chuck preferably has a reducing cross-sectional area extending from the electrode to the deposition substrate so that electrical current is concentrated and resistive heating increases. The purpose of the chuck is to maintain a temperature below deposition temperature at the lower wider end and to maintain a temperature above deposition temperature at the upper narrower end. The chuck is preferably conical in shape. The chuck, deposition substrate, and bridge are preferably made from graphite or more preferably from high purity graphite with total ash content of less than 50000 ppm and preferably less than 5000 ppm and highly preferably less than 500 ppm. The deposition substrate is also preferably made from SiC. According to a further aspect of the present invention contact between first metal electrode and SiC growth substrate is in a different plane than the contact between second metal electrode and SiC growth substrate. The second electrode can preferably be arranged or provided on an opposite side of the process chamber and/or as part of the bell jar.

The process chamber is according to a preferred embodiment of the present invention at least surrounded by a base plate, a side wall section and a top wall section. This embodiment is beneficial since the process chamber can be isolated respectively defined by the base plate, side wall section and top wall section. The baseplate is preferably also disposed with a plurality of gas inlet ports and one gas outlet port or multiple a gas outlet ports. The gas inlet ports and outlet port are arranged so as to create an optimal flow of feed gas inside the CVD reactor respectively SiC production reactor, in particular SiC PVT source material production reactor, such that fresh feed gas is continually brought in contact with the deposition surfaces on the deposition substrates.

The gas inlet unit is according to a further preferred embodiment of the present invention coupled with at least one feed-medium source, wherein the one feed-medium source is a Si and C feed-medium source, wherein the Si and C feed-medium source provides at least Si and C, in particular SiCl3(CH3), and wherein a carrier gas feed-medium source provides a carrier gas, in particular H2, or wherein the gas inlet unit is coupled with at least two feed-medium sources, one of the two feed-medium sources is a Si feed medium source, wherein the Si feed medium source provides at least Si, in particular a Si gas according to the general formula SiH4-y Xy ( X=[CI, F, Br, J] und y= [0..4], and another one of the two feed-medium sources is a C feed medium source, wherein the C feed medium source provides at least C, in particular natural gas, Methane, Ethan, Propane, Butane and/or Acetylene, and wherein a carrier gas medium source provides a carrier gas, in particular H2.

Alternatively the first feed medium is a Si feed medium, in particular a Si gas according to the general formula SiH4-y Xy ( X=[CI, F, Br ,J] und y= [0..4], wherein the gas inlet unit is coupled with at least one feed-medium source, wherein a Si and C feed-medium source provides at least Si and C, in particular SiCl3(CH3) and wherein a carrier gas feed-medium source provides a carrier gas, in particular H2, or wherein the gas inlet unit is coupled with at least two feed-medium sources, wherein a Si feed medium source provides at least Si, in particular the Si feed medium source provides a first feed medium, wherein the first feed medium is a Si feed medium, in particular a Si gas according to the general formula SiH4-y Xy ( X=[CI, F, Br, J] und y= [0..4], and wherein a C feed medium source provides at least C, in particular the C feed medium source provided a second feed medium, wherein the second feed medium is a C feed medium, in particular natural gas, Methane, Ethan, Propane, Butane and/or Acetylene, and wherein a carrier gas medium source provides a third feed medium, wherein the third feed medium is a carrier gas, in particular H2.

Natural gas preferably defines a gas having multiple components, wherein the largest component is methane, in particular more than 50% [mass] is methane and preferably more than 70%[mass] is methane and highly preferably more than 90%[mass] is methane and most preferably more than 95%[mass] or more than 99%[mass] is methane.

Thus, the SiC production reactor respectively the CVD SiC apparatus is preferably also equipped with a feed gas unit respectively a medium supply unit for feeding the feed gas to the gas inlet unit. The feed gas unit respectively medium supply unit ensures the feed gases are heated to the right temperature and mixed in the right ratios before they are pumped into the CVD reactor respectively SiC production reactor, in particular SiC PVT source material production reactor. The feed gas unit respectively medium supply unit begins with pipes and pumps which transport feed gases from their respective sources, in particular storage tanks, to the proximity of the CVD reactor respectively SiC production reactor, in particular SiC PVT source material production reactor. Here the mass flowrate of preferably each feed gas is preferably controlled by a separate mass flow meter connected to an overall process control unit so that the correct ratio of the various feed gases can be achieved. The separate feed gases are then preferably mixed in a mixing unit, in particular of the medium supply unit, and pumped into the CVD reactor respectively SiC production reactor, in particular SiC PVT source material production reactor, via the gas inlet unit, in particular via multiple gas inlet ports of the gas inlet unit. Preferably the feed gas unit respectively medium supply unit is able to mix three feed gases including an Si-bearing gas such as STC and/or TCS, a C-bearing gas such as methane, and a carrier gas such as H. In another preferred embodiment of the invention, there is a feed gas that bears both Si and C such as MTCS and the feed gas unit mixes two gases instead of three, namely MTCS and H. It should be noted that STC, TCS, and MTCS are liquid at room temperature. As such a preheater can be required upstream of the gas inlet unit, in particular upstream of the feed gas unit respectively medium supply unit to first heat these feed liquids so that they become feed gases ready for mixing with the other feed gases.

Preferably the gases are mixed such that there is a 1:1 atomic ratio between Si and C. In some cases, it may be more preferably to mix the gases such that there is a different atomic ratio between the Si and the C. Sometimes it is desirable to maintain the deposition surfaces at the higher end of the deposition temperature range of 1300 to 1600°C to achieve a faster deposition rate. However, in such a condition there is the possibility of excess C deposition in the SiC. This can be moderated by mixing the feed gases such that the Si:C ratio is higher than 1:1, preferably 1:1.1 or 1:1.2, or 1:1.3. Conversely, sometimes it is desirable to maintain the deposition surfaces at the lower end of the deposition temperature range to achieve a slow stress-free deposition. In such a condition there is the possibility of excess Si deposition in the SiC. This can be moderated by mixing the feed gases such that the Si:C ratio is lower than 1:1, preferably 1:0.9, or 1:0.8, or 1:0.7.

A further important consideration for the feed gas mixture is the atomic ratio of H to Si and C. Excess H can dilute the Si and C and reduce the deposition rate. It can also increase the volume of vent gases exiting the CVD reactor respectively SiC production reactor, in particular SiC PVT source material production reactor, and complicate any treatment and recycling of these vent gases. On the other hand, insufficient H can retard the chemical reaction chain that results in the deposition of SiC. The molar ratio of H₂ to Si is preferably in the range of 2:1 to 10:1 and more preferably between 4:1 and 6:1.

According to a further embodiment of the present invention more or up to 4 or preferably 6 or 8 more or up to or highly preferably more or up to 16 or 32 or 64 or most preferably up to 128 or up to 256 SiC growth substrates can be arranged inside one SiC production reactor.

This embodiment is beneficial since the output of the SiC reactor can be significantly increased by adding additional SiC growth substrates.

A control unit for setting up a feed medium supply of the one feed-medium or the multiple feed-mediums into the process chamber is provided according to a further preferred embodiment of the present invention, wherein the control unit is configured to set up the feed medium supply between a minimum amount of feed medium supply [mass] per min. and a maximum amount of feed medium supply [mass] per min., wherein the minimum amount of feed medium supply [mass] per min. corresponds to a deposited minimum amount of Si [mass] and a minimum amount of C [mass] at a defined mass growth rate, wherein the defined mass growth rate is larger than 0.1 g per hour and per cm2 of the SiC growth surface, wherein the maximum amount of feed medium supply per min is up to 30% [mass] or to 20% [mass] or up to 10% [mass] or up to 5% [mass] or up to 3% [mass] higher compared to the minimum amount of feed medium supply. This embodiment is beneficial since the feed medium supply can be controlled in dependency of the desired SiC conditions.

The control unit is according to a further preferred embodiment of the present invention configured to control the current flow through the SiC growth substrate/s to maintain the surface temperature of the SiC growth substrate/s or to set up the surface temperature of the deposited SiC. This embodiment is beneficial since the deposition of the SiC can be maintained by setting up the required temperature conditions.

The control unit is according to a further preferred embodiment of the present invention configured to control the current flow and the amount of feed medium supply for at least one hour and preferably for at least two hours or four hours or six hours to continuously deposit SiC with the defined surface growth rate and/or with a defined radial growth rate. This embodiment is beneficial since large SiC solids can be generated.

The control unit is according to a further preferred embodiment of the present invention a hardware arrangement configured to modify the current flow, wherein modification of the current flow within a first defined time span from the start of a production run are predefined. This embodiment is beneficial since the hardware can be adapted to a defined process, thus additional sensors are not necessary. The first-time span is preferably one hour or more than one hour or up to 60% of the duration of the production run or up to 80% of the duration of the production run or up to 90% of the duration of the production run or up to 100% of the duration of the production run. The hardware arrangement is preferably configured to modify the amount of feed medium supply, wherein modification of the amount of feed medium supply within a second defined time span from the start of a production run is predefined, wherein the second time span is one hour or more than one hour or up to 60% of the duration of the production run or up to 80% of the duration of the production run or up to 90% of the duration of the production run or up to 100% of the duration of the production run.

At least one sensor is according to a further preferred embodiment of the present invention provided, wherein the sensor is coupled with the control unit to provide sensor signals or sensor data to the control unit, wherein the control unit controls current flow and the amount of feed medium supply in dependency of the sensor signals or sensor data of the at least one sensor, wherein the at least one sensor is a temperature sensor for monitoring the surface temperature of at least one of the substrates. At least one temperature sensor is preferably a camera, in particular an IR camera, wherein preferably multiple temperature sensors are provided, wherein the number of temperature sensors corresponds to the number of SiC growth substrates, wherein per 10 SiC growth substrates at least 1, in particular 2 or 5 or 10 or 20, temperature sensor is provided or wherein per 5 SiC growth substrates at least 1, in particular 2 or 5 or 10 or 20, temperature sensor is provided or wherein per 2 SiC growth substrates at least 1, in particular 2 or 5 or 10 or 20, temperature sensor is provided, wherein the temperature sensor preferably outputs temperature sensor signals or temperature sensor data representing a measured temperature, in particular surface temperature. This embodiment is beneficial since the conditions inside the SiC production reactor can be immediately adjusted.

At least one substrate diameter measuring sensor is according to a further preferred embodiment of the present invention provided, wherein the substrate diameter measuring sensor is preferably an IR camera for determining substrate diameter growth, wherein the substrate diameter measuring sensor preferably outputs diameter measuring signals or diameter measuring data representing a measured substrate diameter or a variation of a measured substrate diameter and/or a resistance determination means for determining electrical resistance variation for determining substrate diameter growth, wherein the substrate diameter measuring sensor preferably outputs diameter measuring signals or diameter measuring data representing a measured substrate diameter or a variation of a measured substrate diameter. This embodiment is beneficial since in dependency of the measured data or values parameter like current flow or feed medium supply can be amended, in particular increased.

One valve or multiple vales is/are according to a further preferred embodiment of the present invention provided, wherein the one or multiple valves are configured to be actuated in dependency of the measured temperature, in particular in dependency of the temperature sensor signals or temperature sensor data and/or wherein the one or multiple valves are configured to be actuated in dependency of the measured substrate diameter, in particular in dependency of the diameter measuring signals or diameter measuring data. The one valve or the multiple valves can be part of the gas inlet unit. This embodiment is beneficial since a feed medium flow and/or vent gas flow can be controlled. Thus, the control unit is according to a further preferred embodiment of the present invention configured to increasing the electrical energizing of the at least one SiC growth substrate over time, in particular to heat a surface of the deposited SiC to a temperature between 1300°C and 1800°C

The power supply unit for providing the current is according to a further preferred embodiment of the present invention configured to provide current in dependency of the diameter measuring signals or diameter measuring data. This embodiment is beneficial since a feed medium flow and/or vent gas flow can be controlled.

Thus, the control unit is preferably configured to receive the temperature sensor signals or temperature sensor data and/or the diameter measuring signals or diameter measuring data and to process the temperature sensor signals or temperature sensor data and/or the diameter measuring signals or diameter measuring data and/or to control the one or multiple vales and/or the power supply unit.

The control unit is according to a further preferred embodiment of the present invention configured to control feed-medium flow and temperature of the surface of the deposited SiC for depositing SiC at the set deposition rate, in particular perpendicular deposition rate, for more than 2hours, in particular for more or up to 3 hours or for more or up to 5 hours or for more or up to 8 hours or preferably for more or up to 10 hours or highly preferably for more or up to 15 hours or most preferably for more or up to 24 hours or up to 72h or up to 100h. This embodiment is beneficial since a large amount of SiC can be grown.

The base plate comprises according to a further preferred embodiment of the present invention at least one cooling element, in particular a base cooling element, for preventing heating the base plate above a defined temperature and/or the side wall section comprises at least one cooling element, in particular a bell jar cooling element, for preventing heating the side wall section above a defined temperature and/or the top wall section comprises at least one cooling element, in particular a bell jar cooling element, for preventing heating the top wall section above a defined temperature.

This embodiment is beneficial since the present invention discloses a CVD SiC apparatus for large volume commercial production of ultrapure bulk CVD SiC. The central equipment in the CVD SiC apparatus is the CVD unit respectively CVD reactor respectively SiC production reactor, in particular SiC PVT source material production reactor. The CVD reactor respectively SiC production reactor, in particular SiC PVT source material production reactor, preferably comprises a cooling element, in particular a double walled fluid, in particular water or oil, cooled lower housing respectively baseplate and a double walled liquid cooled upper housing respectively bell jar. The inner walls of the baseplate and in particular the bell jar are preferably made of materials with service temperatures compatible with the operating temperatures of the CVD reactor respectively SiC production reactor, in particular SiC PVT source material production reactor. In particular, the inner wall of the bell jar can be made from stainless steel. Preferably, this inner wall is additionally or alternatively coated with a reflective coating such as preferably silver or preferably gold to reflect back radiant energy and minimize heat losses and therefore electricity costs. The bell jar and/or the base plate are preferably made of stainless steel that withstands high temperatures. However, current high temperature steels with additions of chromium, nickel, cerium or yttrium only withstand temperatures up to 1300°C (in air). As an example, the steel EN 1.4742 (X10CrAlSi18) is heat resistant up to temperatures of 1000°C. In another example the alloy steel EN 2.4816 (UNS N06600) withstands temperature of 1250°C, melts above 1370°C, however its tensile strength drops to less than 10% of its room temperature value at temperatures above 1100°C. Therefore, none of these steels can withstand the enormous temperature required for SiC absorption of more than 1300°C.

It is therefore beneficial to provide a cooling element to reduce the temperature of the bell jar and/or the base plate to a level that is acceptable for the usage of high temperature stainless steel.

The baseplate is preferably disposed with one or multiple fluid, in particular water or oil, cooled electrodes for providing electrical through-connections to the CVD reactor respectively SiC production reactor, in particular SiC PVT source material production reactor, for the purpose of resistively heating deposition substrates. The cooling element is according to a further preferred embodiment of the present invention an active cooling element.

The base plate and/or side wall section and/or top wall section comprises according to a further preferred embodiment of the present invention a cooling fluid guide unit for guiding a cooling fluid, wherein the cooling fluid guide unit is configured limit heating of the base plate and/or side wall section and/or top wall section to a temperature below 1300°C. This embodiment is beneficial since a metal, in particular steel bell jar can be provided. A steel bell jar is beneficial since it can be produced significant larger compared to quartz bell jars.

A base plate and/or side wall section and/or top wall section sensor unit is provided according to a further preferred embodiment of the present invention to detect temperature of the base plate and/or side wall section and/or top wall section and to output a temperature signal or temperature data, and a fluid forwarding unit is provided for forwarding the cooling fluid through the fluid guide unit. This embodiment is beneficial since a continuous cooling can take place without loss or contamination of the cooling fluid and/or the process chamber.

The fluid forwarding unit is according to a further preferred embodiment of the present invention configured to be operated in dependency of the temperature signal or temperature data provided by the base plate and/or side wall section and/or top wall section sensor unit. This embodiment is beneficial since metal impurities can be avoided in case the bell jar and/or base plate are operated at temperatures below 1000°C and preferably below 800°C and highly preferably below 400°C respectively in case the bell jar and/or base plate are cooled to temperatures below 1000°C and preferably below 800°C and highly preferably below 400°C.

The cooling fluid is according to a further preferred embodiment of the present invention oil or water, wherein the water preferably comprises at least one additive, in particular corrosion inhibiter/s and/or antifouling agent/s (biocides). This embodiment is beneficial since the cooling liquid can be modified to avoid defects or contaminations of the SiC production reactor.

The cooling element is according to a further preferred embodiment of the present invention a passive cooling element. This embodiment is beneficial since a passive cooling element does not require constant monitoring.

The cooling element is according to a further preferred embodiment of the present invention at least partially formed by a polished steel surface of the base plate, the side wall section and/or the top wall section. The cooling element is according to a further preferred embodiment of the present invention a coating, wherein the coating is formed above the polished steel surface and wherein the coating is configured to reflect heat. The coating is according to a further preferred embodiment of the present invention a metal coating or a comprises metal, in particular silver or gold or chrome, or alloy coating, in particular a CuNi alloy. The emissivity of the polished steel surface and/or of the coating is according to a further preferred embodiment of the present invention below 0.3, in particular below 0.1 or below 0.03. This embodiment is beneficial since due to the polished surface and/or the coating a high amount of heat radiation can be reflected back to the SiC growth surface.

Thus, at least one section of the bell jar surface and/or at least one section of the base unit surface comprises according to a further preferred embodiment of the present invention a coating, in particular a reflective coating, wherein the section of the bell jar surface and/or the section of the base unit surface delimits the reaction space, wherein the coating is a metal coating, in particular comprises or consists of gold, silver, aluminum and/or platinum and/or wherein the coating is configured to reflect at least 2% or at least 5% or at least 10% or at least 20% of the radiant energy radiated during one production run onto the coating.

The base plate comprises according to a further preferred embodiment of the present invention at least one active cooling element and one passive cooling element for preventing heating the base plate above a defined temperature and/or the side wall section comprises at least one active cooling element and one passive cooling element for preventing heating the side wall section above a defined temperature and/or the top wall section comprises at least one active cooling element and one passive cooling element for preventing heating the top wall section above a defined temperature.

The side wall section and the top wall section are formed according to a further preferred embodiment of the present invention by a bell jar, wherein the bell jar is preferably movable with respect to the base plate. More than 50% [mass] of the side wall section and/or more than 50% [mass] of the top wall section and/or more than 50% [mass] of base plate is according to a further preferred embodiment of the present invention made of metal, in particular steel. This embodiment is beneficial since large steel bell jars can be manufactured causing a significant increase in process chamber volume and therefore in potential SiC material. Thus a bell jar is preferably provided, wherein the bell jar comprises according to a further preferred embodiment of the present invention a contact region for forming an interface with the base unit, wherein the interface is sealed against leakage of gaseous species, wherein the bell jar comprises a bell jar cooling unit, wherein the bell jar cooling element forms at least one channel or trench or recess for holding or guiding a bell jar cooling liquid, wherein the bell jar cooling element is configured to cool at least one section of the bell jar and preferably the entire bell jar below a defined temperature respectively to remove a defined amount of heat per min during the production run. The bell jar cooling element and/or base plate cooling element is preferably controlled by the control unit. Additionally, or alternatively the bell jar cooling element and/or base cooling element are coupled with each other to form one major cooling unit.

The base unit comprises according to a further preferred embodiment of the present invention at least one base cooling element for cooling the base unit, wherein the base cooling element forms at least one channel or trench or recess for holding or guiding a base cooling liquid. The base cooling element is according to a further preferred embodiment of the present invention arranged in an area of at least one of the first metal electrodes and preferably also in an area of at least one second metal electrode, wherein the base cooling element is configured to cool the base unit, in particular a surface of the base unit, which is arranged inside the reactor, in the area of at least one of the first metal electrodes and preferably also in the area of the at least one second metal electrode below a defined temperature respectively to remove a defined amount of heat per min from the base unit or the base cooling element is configured to cool the entire base unit during a complete production run below a defined temperature respectively to remove a defined amount of heat per min during the production run. This embodiment is beneficial since electrodes can be operated with high current without damaging the SiC reactor.

The first metal electrode and the SiC growth substrate are according to a further preferred embodiment of the present invention connected with each other via a first graphite chuck and/or the second metal electrode and the SiC growth substrate are connected with each other via a second graphite chuck. This embodiment is beneficial since the current can be introduced in a homogeneous manner into the SiC growth substrate. The first graphite chuck and/or the second graphite chuck is/are according to a further preferred embodiment of the present invention mounted to the base unit.

The first metal electrodes and second metal electrodes are according to a further preferred embodiment of the present invention sealed from the reaction chamber to avoid metal species contamination of the reaction chamber by metal species of the first metal electrodes and second metal electrodes, the first metal electrodes and second metal electrodes preferably enter the base unit from a first side of the base unit, wherein the first metal electrodes and second metal electrodes preferably extend inside the base unit to another side of the base unit, wherein the other side of the base unit is opposite to the first side, wherein the first metal electrodes and preferably the second metal electrodes extend inside the base unit to a sealing level below a process chamber surface of the base unit, wherein the process chamber surface is formed on the other side of the base unit. This embodiment is beneficial since contaminations of the reaction space can be avoided.

A sealing wall member is according to a further preferred embodiment of the present invention formed between the sealing level and the process chamber surface, wherein the sealing wall member separates the SiC growth substrate from the first metal electrode and preferably from the second metal electrode. This embodiment is beneficial since short circuiting can be prevented.

The control unit is according to a further preferred embodiment of the present invention configured to control the current flow through the SiC growth substrate/s to maintain the surface temperature of the SiC growth substrate/s or to set up the surface temperature of the deposited SiC, wherein the control unit is coupled to a power supply unit for providing the current, wherein the power supply unit is configured to receive power supply data or power supply signals provided by the control unit; and/or the feed medium supply of the one feed-medium or the multiple feed-mediums into the process chamber, wherein the control unit is coupled to a medium supply unit for providing the one feed-medium or the multiple feed-mediums to the gas inlet unit, wherein the medium supply unit is configured to receive medium supply data or medium supply signals provided by the control unit; and/or a cooling of the base unit, wherein the control unit is coupled to the base cooling element for cooling the base unit, wherein the base cooling element is configured to receive base cooling data or base cooling signals provided by the control unit, and/or a cooling of the bell jar, wherein the control unit is coupled to the bell jar cooling element for cooling the bell jar, wherein the bell jar cooling element is configured to receive bell jar cooling data or bell jar cooling signals provided by the control unit, and/or the control unit is configured to set up a deposition rate, in particular perpendicular deposition rate, of more than 200 µm/h, in particular by controlling at least the power supply unit and the medium supply unit. This embodiment is beneficial since the control unit can control multiple parameters, thus the output can be increased by operating the heating, feeding and cooling units at the same time.

The medium supply unit is according to a further preferred embodiment of the present invention configured to feed the one feed-medium or multiple feed-mediums at a pressure of more than 1 bar, in particular of more than 1.2bar or preferably of more than 1.5bar or highly preferably of more than 2bar or 3bar or 4bar or 5bar respectively of up to 10 bar or up to 20 bar, into the process chamber. Additionally, or alternatively the medium supply unit is according to a further preferred embodiment of the present invention configured to feed the one feed-medium or multiple feed-mediums and a carrier gas at a pressure of more than 1 bar, in particular of more than 1.2bar or 1.5bar or 2bar or 3bar or 4bar or 5bar, into the process chamber. This embodiment is beneficial since the material density is high inside the process chamber, thus a high amount of Si and C material reaches the SiC growth surface and therefore causes an enhanced SiC growth.

The above-mentioned object is also solved by a usage of a wafer produced according to a method according to claim 10 as carrier wafer for holding a monocrystalline SiC wafer, wherein the monocrystalline SiC wafer has a height of less than 50µm. This solution is beneficial since the carrier wafer is produced with very low costs.

The above-mentioned object is also solved according to claim 12 by a carrier wafer, in particular produced according to claim 10, wherein the carrier wafer has a diameter of at least 7,5cm, a height of at least 200µm and wherein the carrier wafer is predominantly formed by a 3C crystal structure. This embodiment is beneficial since the carrier wafer can have a large size and therefore allow bonding it with monocrystalline wafers of the same size.

The 3C crystal structure is according to a preferred embodiment of the present invention Nitrogen doped, in particular more than 2000ppba nitrogen, and comprises an electric resistivity < 0.01 Ohm cm. This embodiment is beneficial since preferred mechanical and electrical properties can be provided to allow usage of the carrier wafer in a wide range of different use cases.

The grain orientation of the 3C crystal structure varies according to a preferred embodiment of the present invention between 0° and 80°. This embodiment is beneficial since the SiC piece respectively the carrier wafer is removed from the grown crust respectively from one quarter of the grown crust.

The grain orientation of the 3C crystal structure varies according to a preferred embodiment of the present invention more than 80°. This embodiment is beneficial since the SiC piece respectively the carrier wafer is removed from at least two quarters of the grown crust and preferably also from the center of the physical structure.

The above-mentioned object is also solved according to claim 13 by a crack-free SiC piece, in particular produced according to any of claims 1 to 8. Crack-free SiC piece is predominantly formed by a 3C crystal structure, wherein the dimensions of the crack-free SiC piece are at least 2cm × 2cm × 1cm. This embodiment is beneficial since the crack-free piece can be used to produce multiple or different or large elements respectively devices.

The grain orientation of the 3C crystal structure varies according to a preferred embodiment of the present invention between 0° and 80° and preferably below 70° and most preferably below 60° or alternatively above 90° and preferably above 120° or particular preferably above 160° and most preferably above 220°. This embodiment is beneficial since the SiC piece or SiC pieces can be removed in dependency of the required grain orientation.

The density of the crack-free SiC piece is according to a preferred embodiment of the present invention more than 3 g/cm3. This embodiment is beneficial since the mechanical and/or electrical and/or chemical properties of the crack-free SiC piece are enhanced. Due to better mechanical stability carrier wafers can be thinner and therefore allow less energy consuming processing.

The above-mentioned object is also solved according to claim 14 by a method for producing predefined PVT source material pieces for filling a source material receiving space of PVT reactor. The PVT source material is SiC, wherein the SiC predominantly has a 3C crystal structure. The method preferably comprises at least the steps: Providing a CVD reactor, wherein the CVD reactor comprises at least one SiC growth substrate, wherein the at least one SiC growth substrate comprises a main body, a first power connection and a second power connection, wherein the main body has a main body length, wherein the main body length extends between the first power connection and the second power connection, wherein the first power connection is configured to conduct power into the main body for heating the main body and wherein the second power connection is configured to conduct electric power conducted via the first power connection into the main body out of the main body, wherein the main body forms a physical structure, wherein the physical structure forms a deposition surface for deposition of SiC. The method preferably also comprises the step of growing a SiC solid by depositing SiC on the physical structure in the CVD reactor, wherein the at least one SiC piece is part of the SiC solid, wherein the deposited SiC has a minimal thickness of at least 1cm. The method preferably also comprises the step of removing the at least one SiC piece from the SiC solid, wherein the at least one SiC piece has a cross-sectional size of at least 4cm2 and preferably of at least 8cm2 and highly preferably of at least 12cm2 and a thickness of at least 0,1cm and preferably of at least 1cm and highly preferably of at least 2cm, wherein the at least one SiC piece has a shape configured to fill at least 75% of a volume of a defined source material receiving space of a defined PVT reactor or wherein the at least one SiC piece has a shape configured to fill together with at least one further SiC piece having the same shape at least 75% of a volume of a defined source material receiving space of a defined PVT reactor. This solution is beneficial since due to the block shape of the SiC piece/s more mass of SiC can be provided compared to powder as source material within a defined receiving space of a PVT reactor and therefore allows larger growth of a monocrystalline SiC crystal during one production run.

The above-mentioned object is also solved according to a SiC piece, in particular produced according to claim 14, wherein the SiC piece is predominantly formed by a 3C crystal structure, wherein the dimensions of the crack-free SiC piece are at least 2cm × 2cm × 1cm.

The grain orientation of the 3C crystal structure varies according to a preferred embodiment of the present invention between 0° and 80° and preferably below 70° and most preferably below 60° or alternatively above 90° and preferably above 120° or particular preferably above 160° and most preferably above 220°. This embodiment is beneficial since the SiC piece or SiC pieces can be removed in dependency of the required grain orientation.

The density of the SiC piece is according to a preferred embodiment of the present invention more than 3 g/cm3. This embodiment is beneficial since the mechanical and/or electrical and/or chemical properties of the crack-free SiC piece are enhanced. Due to better mechanical stability carrier wafers can be thinner and therefore allow less energy consuming processing.

The above-mentioned object is also solved according to claim 15 by a method for producing SiC material. Said method preferably comprises the steps: Providing at least one furnace apparatus for growing SiC crystals, wherein the furnace apparatus comprises a furnace unit, wherein the furnace unit comprises a furnace housing with an outer surface and an inner surface, at least one crucible unit, wherein the crucible unit is arranged inside the furnace housing, wherein the crucible unit comprises a crucible housing, wherein the housing has an outer surface and an inner surface, wherein the inner surface at least partially defines a crucible volume, wherein a receiving space for receiving a solid SiC source material is arranged or formed inside the crucible volume, wherein a seed holder unit for holding a defined seed wafer is arranged inside the crucible volume, wherein the furnace housing inner wall and the crucible housing outer wall define a furnace volume, at least one heating unit for heating the source material, wherein the receiving space for receiving the source material is at least in parts arranged below the seed holder unit, Arranging source material in the receiving space within the crucible housing, wherein the source material is made of exactly one SiC piece, wherein the source material fills at least 75% and preferably at least 90% and highly preferably at least 95% and most preferably at least 98% of a volume of the receiving space or wherein the source material is made of multiple SiC pieces preferably produced according to claim 14, wherein at least a plurality and preferably all of the multiple SiC pieces have the same shape, wherein the source material fills at least 75% and preferably at least 90% and highly preferably at least 95% and most preferably at least 98% of a volume of the receiving space, Heating the source material, Feeding a carrier gas into the crucible housing. This solution is beneficial since larger monocrystalline SiC crystals can be produced during one run, since more mass of SiC can be arranged inside the receiving space compared to prior art source material.

Document PCT/EP2021/082340 discloses a furnace apparatus which can be used to carry out the before mentioned method according to the present invention. The subject-matter of PCT/EP2021/082340 is entirely incorporated into the present subject-matter by reference. Further advantages, objectives and features of the present invention are explained with reference to the following description of accompanying drawings, in which the device(s) according to the invention are shown by way of example. Components or elements of the device or reactor or system or SiC growth substrate according to the invention, which at least substantially correspond in the figures with respect to their function, can be marked with the same reference signs, whereby these components or elements do not have to be numbered or explained in all figures.

Individual or all representations of the figures described in the following are preferably to be regarded as construction drawings, i.e. the dimensions, proportions, functional relationships and/or arrangements resulting from the figure or figures preferably correspond exactly or preferably substantially to those of the device according to the invention or the product according to the invention or the method according to the invention.
- Fig. 1: schematically shows a first example of a CVD reactor according to the present invention,
- Fig. 2: schematically shows a second example of a CVD reactor according to the present invention,
- Fig. 3: schematically shows a third example of a CVD reactor according to the present invention,
- Fig. 4a: schematically shows a CVD reactor before production run and
- Fig. 4b: schematically shows a CVD reactor after a production run,
- Fig. 5: schematically shows the production of SiC pieces and SiC carrier wafer and composite wafers,
- Fig. 6: shows a PVT reactor, which can be operated with source material produced according to the invention,
- Fig. 7: shows a PVT reactor filled with large solid SiC source material pieces, and
- Fig. 8a/b: show different positions of SiC pieces inside the entire CVD SiC structure.

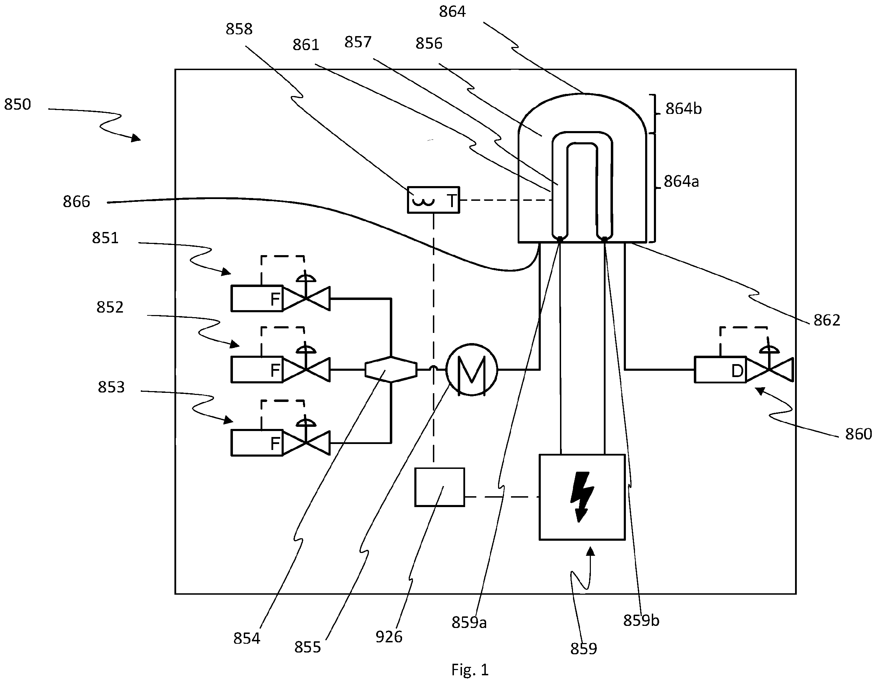

Fig. 1 shows an example of a manufacturing device 850 for producing SiC material, in particular 3C-SiC material. This device 850 comprises a first feeding device 851, a second feeding device 852 and a third feeding device 853. The first feed device 851 is preferably designed as a first mass flow controller, in particular for controlling the mass flow of a first source fluid, in particular a first source liquid or a first source gas, wherein the first source fluid preferably comprises Si, in particular e.g. silanes/chlorosilanes of the general composition SiH4-mClm or organochlorosilanes of the general composition SiR4-mClm (where R = hydrogen, hydrocarbon or chlorohydrocarbon). The second feed device 852 is preferably designed as a second mass flow controller, in particular for controlling the mass flow of a second source fluid, in particular a second source liquid or a second source gas, wherein the second source fluid preferably comprises C, e.g. hydrocarbons or chlorohydrocarbons, preferably with a boiling point < 100 °C, particularly preferably methane. The third feed device 853 is preferably designed as a third mass flow controller, in particular for controlling the mass flow of a carrier fluid, in particular a carrier gas, wherein the carrier fluid or carrier gas preferably comprises H or H2, respectively, or mixtures of hydrogen and inert gases.

The reference sign 854 indicates a mixing device or a mixer by which the source fluids and/or the carrier fluid can be mixed with one another, in particular in predetermined ratios. The reference sign 855 indicates an evaporator device or an evaporator by which the fluid mixture which can be supplied from the mixing device 854 to the evaporator device 855 can be evaporated.

The evaporated fluid mixture is then fed to a process chamber 856 or a separator vessel, which is designed as a pressure vessel. At least one deposition element 857 and preferably several deposition elements 857 are arranged in the process chamber 856, wherein Si and C are deposited from the vaporized fluid mixture at the deposition element 857 and SiC is formed.

The reference sign 858 indicates a temperature measuring device, which is preferably provided for determining the surface temperature of the deposition element 857 and is preferably connected to a control device (not shown) by data and/or signal technology.

The reference sign 859 indicates an energy source, in particular for introducing electrical energy into the separating element 857 for heating the separating element. The energy source 859 is thereby preferably also connected to the control device in terms of signals and/or data. Preferably, the control device controls the energy supply, in particular power supply, through the deposition element 857 depending on the measurement signals and/or measurement data output by the temperature measurement device 858.

Furthermore, a pressure holding device is indicated by the reference sign 860. The pressure holding device 860 can preferably be implemented by a pressure-regulated valve or the working pressure of a downstream exhaust gas treatment system.

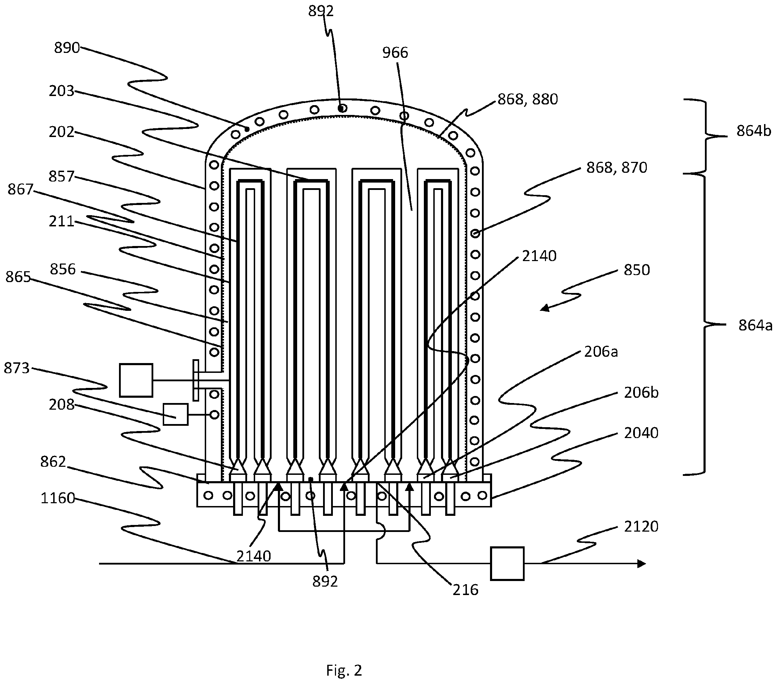

Fig. 2 shows the CVD unit respectively CVD reactor respectively SiC production reactor, in particular SiC PVT source material production reactor, 850 of one preferred embodiment of the present invention. The CVD unit respectively CVD reactor respectively SiC production reactor, in particular SiC PVT source material production reactor, 850 preferably comprises a fluid, in particular oil or water, cooled steel upper housing 202 or bell jar which seals, in particular by means of one or multiple gaskets, against a preferably fluid, in particular oil or water, cooled lower housing 2040 or base plate creating a deposition chamber respectively process chamber 856 which can be pressurized preferably to at least 6 bar, in particular to a pressure between 2 bar and 15bar. The feed gas mixture 1160 preferably enters the deposition chamber respectively process chamber 856 through a plurality of feed gas inlets 2140 and the vent gas 2120 preferably exists through the gas outlet unit respectively vent gas outlet 216. Inside the deposition chamber preferably a plurality of resistively self-heated deposition substrates respectively SiC growth substrate 857 preferably made of graphite or silicon carbide or metal are provided which are connected to chucks 208 which are preferably made of graphite. The chucks 208 are in turn connected to water cooled electrodes 206 preferably made of copper which pass through the baseplate so that they can be connected to an external source of electrical power. The deposition substrates respectively SiC growth substrate 857 are preferably arranged as pairs via cross members 203 to complete an electrical circuit for resistive heating.

The purpose of the chucks 208 is to create a temperature gradient between the electrodes 206 which are in a temperature range of preferably between 850 and 400°C and the deposition substrate respectively SiC growth substrate 857 which is preferably in temperature range of 1300 and 1600°C. The chuck 208 preferably achieves this by having a continuously reducing current flow cross section area resulting in higher and higher resistive heating. Thus, the chuck 208 preferably has a conical shape. In this manner the starting point for the deposition of CVD SiC crust 211 can be controlled preferably to a point for example midway up the chuck 208 such that the final deposition substrate respectively SiC growth substrate 857 with the deposited CVD SiC crust 211 has a structurally strong connection at the bottom and will not break or fall over.

The plurality of feed gas inlets 2140 is preferably designed to create a turbulent gas flow pattern inside the deposition chamber respectively process chamber 856 so as to maximize the contact of fresh feed gas with the surface of the CVD SiC crust 211 being deposited on the deposition substrates respectively SiC growth substrate 857. Additionally, or alternatively it is possible to provide a gas turbulence generating apparatus, in particular inside the process chamber. The gas turbulence generating apparatus can be a ventilator or circulator pump. This ensures that a minimum excess of feed gas mixture 1160 is used to produce a given quantity of CVD SiC crust 211. The vent gas 2120 which contains unreacted feed gas mixture as well as altered Si-bearing gas and HCI gas is forced out of the deposition chamber respectively process chamber 856 through the vent gas outlet by the incoming feed gas mixture 1160.

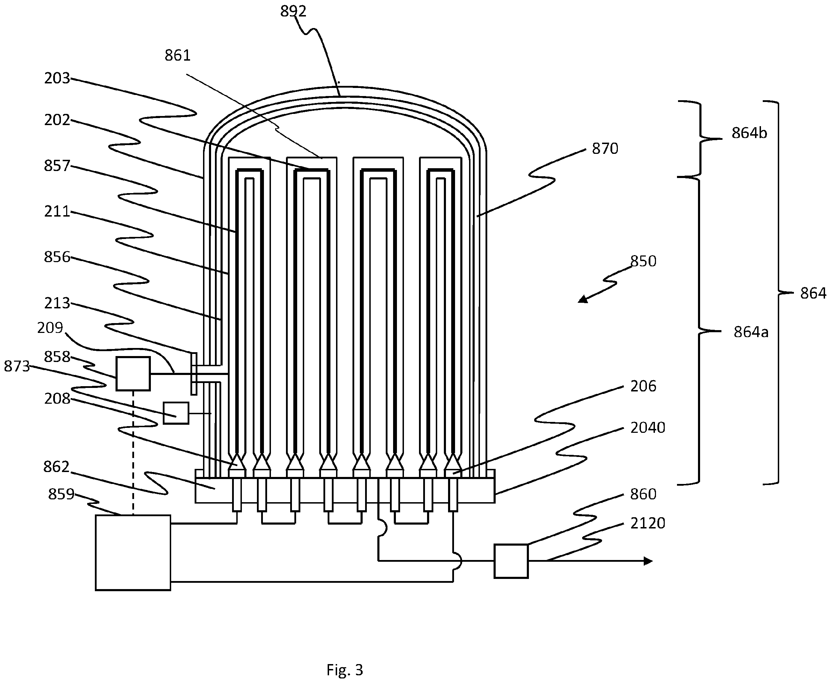

Fig. 3 shows examples of the temperature and pressure control methods for the CVD unit. A temperature control unit respectively temperature measuring device 858 is positioned such that to measure the temperature of the CVD SiC crust 211 along the temperature measurement path 209 preferably through the sight glass 213 which is preferably fluid, in particular oil or water, cooled. The temperature control unit respectively temperature measuring device 858 preferably measures the temperature of the surface of the CVD SiC crust and sends a signal to the power supply unit respectively energy source 859 to increase or decrease power to the deposition substrates respectively SiC growth substrate 857 depending on whether the temperature is below or above the desired temperature respectively. The power supply unit respectively energy source 859 is wired to the fluid, in particular oil or water-cooled electrodes 206 and adjusts voltage and/or current to the fluid, in particular oil or water, cooled electrodes 206 accordingly. The deposition substrates respectively SiC growth substrate 857 are wired in pairs and have connecting cross members at the top so as to form a complete electrical circuit for the flow of current.

Pressure inside the deposition chamber respectively process chamber 856 is adjusted by means of a pressure control unit respectively pressure maintaining device 860 which senses the pressure and decreases or increases the flowrate of vent gas 2120 from the deposition chamber respectively process chamber 856.

Thus, as shown in fig. 2 and 3 the SiC production reactor 850 according to the present invention preferably comprises at least a process chamber 856, wherein the process chamber 856 is at least surrounded by a base plate 862, a side wall section 864a and a top wall section 864b. the reactor 850 preferably comprises a gas inlet unit 866 for feeding one feed-medium or multiple feed-mediums into a reaction space of the process chamber 856 for generating a source medium inside the process chamber 856. The base plate 862 preferably comprises at least one cooling element 868, 870, 880, in particular a base cooling element, for preventing heating the base plate 862 above a defined temperature and/or wherein the side wall section 864a preferably comprises at least one cooling element 868, 870, 880, in particular a bell jar cooling element, for preventing heating the side wall section 864a above a defined temperature and/or wherein the top wall section 864b preferably comprises at least one cooling element 868, 870, 880, in particular a bell jar cooling element, for preventing heating the top wall section 864b above a defined temperature. The cooling element 868 can be an active cooling element 870, thus the base plate 862 and/or side wall section 864a and/or top wall section 864b preferably comprises a cooling fluid guide unit 872, 874, 876 for guiding a cooling fluid, wherein the cooling fluid guide unit 872, 874, 876 is configured limit heating of the base plate 862 and/or side wall section 864a and/or top wall section 864b to a temperature below 1000°C. It is additionally possible that a base plate and/or side wall section and/or top wall section sensor unit 890 is provided to detect the temperature of the base plate 862 and/or side wall section 864a and/or top wall section 864b and to output a temperature signal or temperature data. The at least one base plate and/or side wall section and/or top wall section sensor unit 890 can be arranged as part of a surface or on a surface inside the process chamber, in particular on a surface of the base plate 862 or the side wall section 864a or the top wall section 864b. Additionally or alternatively it is possible to provide one or more base plate and/or side wall section and/or top wall section sensor unit/s 890 inside the base plate 862 or inside the side wall section 864a or inside the top wall section 864b. Additionally or alternatively it is possible to provide a cooling fluid temperature sensor 820 to detect the temperature of the cooling fluid guided through the cooling fluid guide unit 870. A fluid forwarding unit 873 can be provided for forwarding the cooling fluid through the fluid guide unit 872, 874, 876, wherein the fluid forwarding unit 873 is preferably configured to be operated in dependency of the temperature signal or temperature data provided by the base plate and/or side wall section and/or top wall section sensor unit 890 and/or cooling fluid temperature sensor 892. The cooling fluid can be oil or preferably water, wherein the water preferably comprises at least one additive, in particular corrosion inhibiter/s and/or antifouling agent/s (biocides).

Additionally, or alternatively the cooling element 868 is a passive cooling element 880. Thus, the cooling element 868 can be at least partially formed by a polished steel surface 865 of the base plate 862, the side wall section 864a and/or the top wall section 864b, preferably by a polished steel surface 865 of the base plate 862, the side wall section 864a and the top wall section 864b. The passive cooling element 868 can be a coating 867, wherein the coating 867 is preferably formed above the polished steel surface 865 and wherein the coating 867 is configured to reflect heat. The coating 867 can be a metal coating or a comprises metal, in particular silver or gold or chrome, or can be an alloy coating, in particular a CuNi alloy. The emissivity of the polished steel surface 865 and/or of the coating 867 is 0.3, in particular below 0.1 and highly preferably below 0.03.

The base plate 862 can comprise at least one active cooling element 870 and one passive cooling element 880 for preventing heating the base plate 862 above a defined temperature and/or the side wall section 864a can comprise at least one active cooling element 870 and one passive cooling element 880 for preventing heating the side wall section 864a above a defined temperature and/or the top wall section 864b can comprises at least one active cooling element 870 and one passive cooling element 880 for preventing heating the top wall section 864b above a defined temperature.

The side wall section 864a and the top wall section 864b are preferably formed by a bell jar 864, wherein the bell jar 864. The bell jar 864 is preferably movable with respect to the base plate 862.

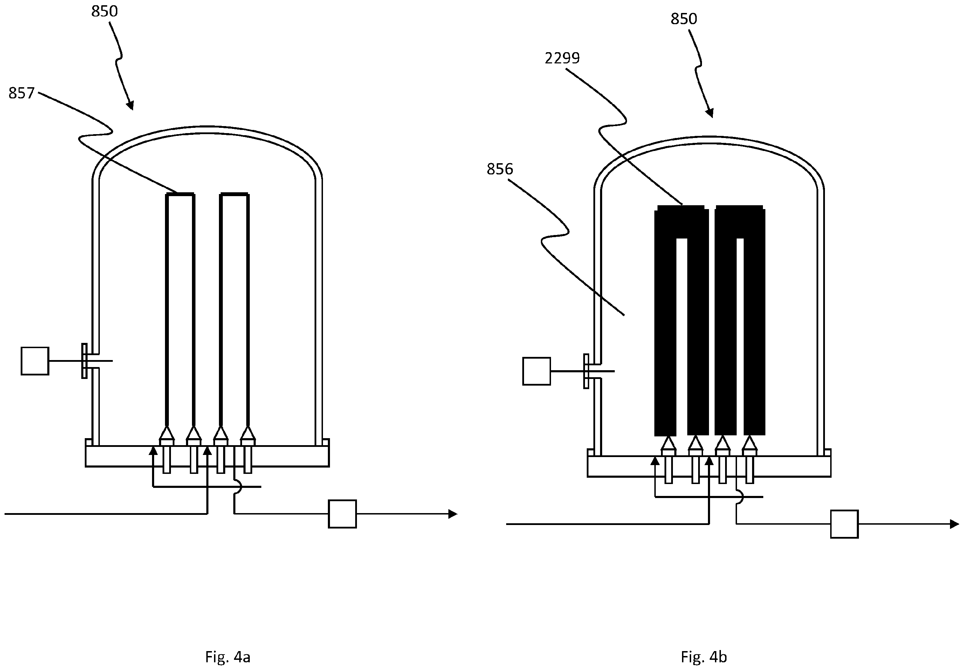

Fig. 4a shows an example of the reactor 850 according to any of figures 1 to 3, wherein the reactor 850 comprises at least one SiC growth substrate 857, in particular two or more than two SiC growth substrates 857. Said SiC growth substrate/s 857 is/are preferably made of SiC, in particular polycrystalline 3C SiC. The reactor 850 can preferably comprise an optional nitrogen inlet for feeding nitrogen into the process chamber 856.

Fig. 4b shows the reactor of fig. 4a after a production run and after cooling down. Reference number 2299 refers to the entire structure comprising the SiC growth substrate 857 and the grown crust 211.

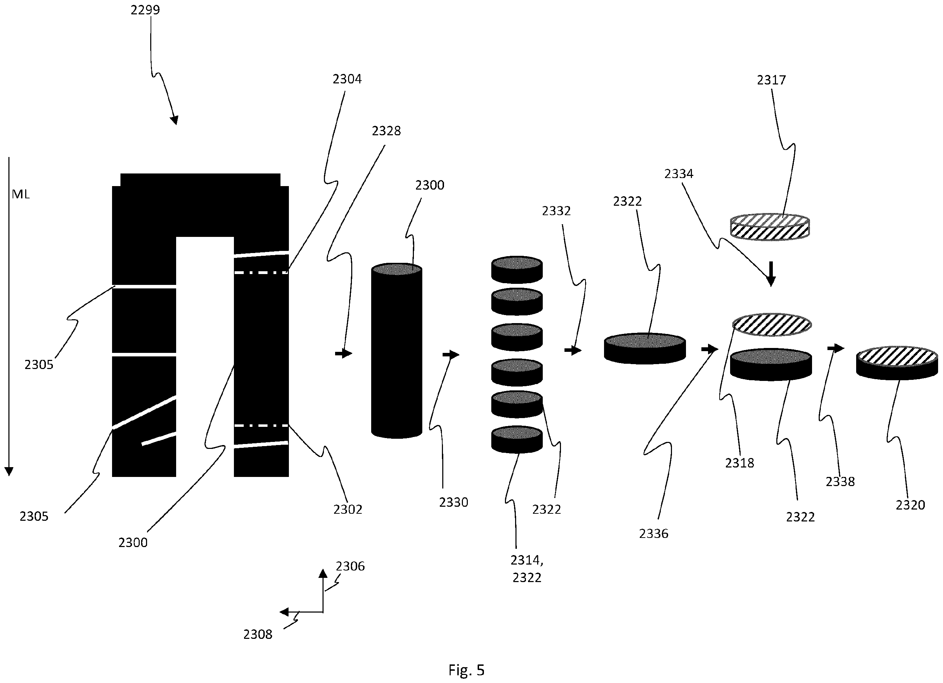

Fig. 5 also shows the entire structure 2299, which comprises one or multiple regions without cracks 2305. One region respectively crack-free SiC piece 2300 without cracks 2305 is preferably formed between a first plane 2302 and a second plane 2304, wherein the first plane 2302 and the second plane 2304 are preferably parallel to each other and arranged in a distance of more than 200µm or preferably more than 500µm or particular preferably more than 2500µm or highly preferably more than 5000µm or most preferably more than or up to 10000µm or in a distance between 500µm and 50000µm. Arrow 2328 indicates a rough sawing step for removing the crack-free SiC piece 2300 from the structure 2299 and/or for removing the crack-free SiC piece 2300 from the crust 211. The crack-free SiC piece 2300 is in a further step 2330 sliced in a plurality of wafers 2322 and preferably in more than two wafers 2322 and particular preferably more than 5 or up to 5 wafer 2322 or highly preferably more than 10 or up to 10 wafer 2322 or most preferably more than 15 or up to 15 wafer 2322 or between 2 and 50 wafer 2322.

One, multiple or all wafers 2322 are preferably processed, in particular lapped, in step 2332. After the step of lapping a step of polishing (reference number 2336) is preferably carried out. Reference number 2317 indicates a SiC monocrystal, wherein according to reference number 2334 a wafer, in particular a monocrystalline wafer thinner than 50µm, is removed from the SiC monocrystal 2317. Reference number 2338 indicates a bonding step for bonding the monocrystalline SiC wafer 2334 and the carrier wafer 2332 and thereby generating the bonded structure 2320.

Thus, the present invention preferably refers to a method for producing at least one crack-free SiC piece at least comprising the step: Providing a CVD reactor 850, wherein the CVD reactor 850 comprises at least one SiC growth substrate 857, wherein the at least one SiC growth substrate 857 comprises a main body 2200, a first power connection 859a and a second power connection 859b, wherein the main body 2200 has a main body length ML, wherein the main body length ML extends between the first power connection 859a and the second power connection 859b, wherein the first power connection 859a is configured to conduct power into the main body 2200 for heating the main body 2200 and wherein the second power connection 859b is configured to conduct electric power conducted via the first power connection 859a into the main body 2200 out of the main body 2200, wherein the main body 2200 forms a physical structure, wherein the physical structure forms a deposition surface 861 for deposition of SiC. Additionally, the step of growing a SiC solid 211 by depositing SiC on the physical structure in the CVD reactor 850, wherein the at least one crack-free SiC piece 2300 is part of the SiC solid 211, wherein the deposited SiC has a minimal thickness of at least 1cm, wherein the at least one SiC piece 2300 is formed between a first plane 2302 and a second plane 2304, wherein the first plane 2302 is perpendicular to the main body length ML and wherein the second plane 2304 is perpendicular to the main body length ML, wherein the distance D between the first plane 2302 and the second plane 2304 is at least 1% and preferably at least 2% and highly preferably at least 5% of the main body length ML. Additionally, the step of removing the at least one crack-free SiC piece 2300 from the SiC solid 211, wherein the at least one crack-free SiC piece 2300 has a cross-sectional size of at least 4cm² and preferably of at least 8cm² and highly preferably of at least 12cm² and a thickness of at least 0,1cm and preferably of at least 1cm and highly preferably of at least 2cm.

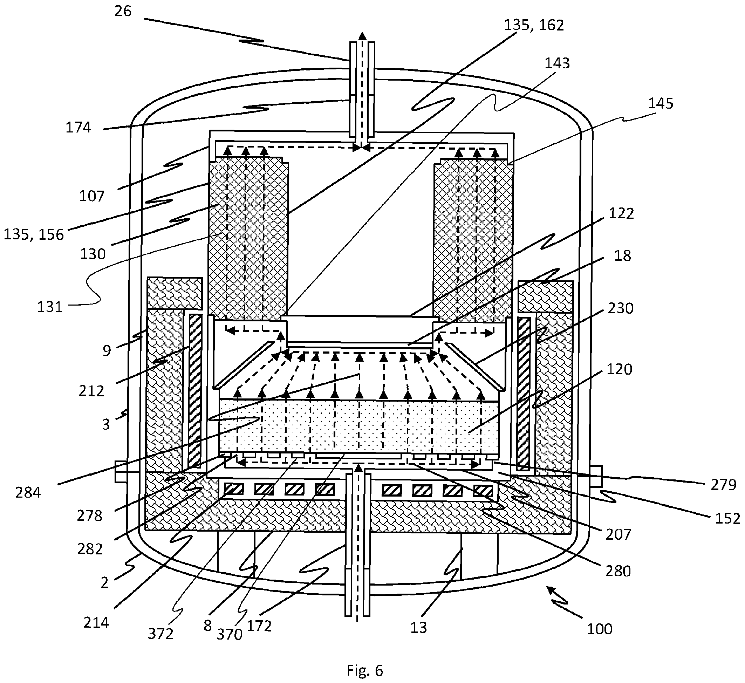

Fig. 6 shows a furnace unit 102. The furnace unit 102 preferably comprises a furnace housing 108 with an outer surface 242 and an inner surface 240, at least one crucible unit 106 and at least one heating unit 124 for heating the source material 120. The crucible unit 106 is preferably arranged inside the furnace housing 108, wherein the crucible unit 106 comprises a crucible housing 110, wherein the housing 110 has an outer surface 112 and an inner surface 114, wherein the inner surface 114 at least partially defines a crucible volume 116, wherein a receiving space 118 for receiving a solid SiC source material 120 is arranged or formed inside the crucible volume 116, wherein a seed holder unit 122 for holding a defined seed wafer 18 is arranged inside the crucible volume 116, wherein the furnace housing inner wall 240 and the crucible housing outer wall 112 define a furnace volume 104, wherein the receiving space 118 for receiving the source material 120 is at least in parts arranged below the seed holder unit 122. The receiving space 118 preferably has a defined volume for receiving a maximum volume of source material 120. Operating the furnace unit 102, in particular PVT reactor, with source material 120 which has a higher density, compared to source material with a lower density allows the production of larger SiC crystals in one run. Thus, usage of source material 120 which is made of exactly one SiC piece 2300 according to the present invention is highly beneficial in case the source material fills at least 75% and preferably at least 90% and highly preferably at least 95% and most preferably at least 98% of the volume of the receiving space 118. Alternatively, usage of multiple SiC pieces is beneficial in case at least a plurality and preferably all of the multiple SiC pieces 2300 have the same shape, wherein the source material 120 fills at least 75% and preferably at least 90% and highly preferably at least 95% and most preferably at least 98% of the volume of the receiving space 118.

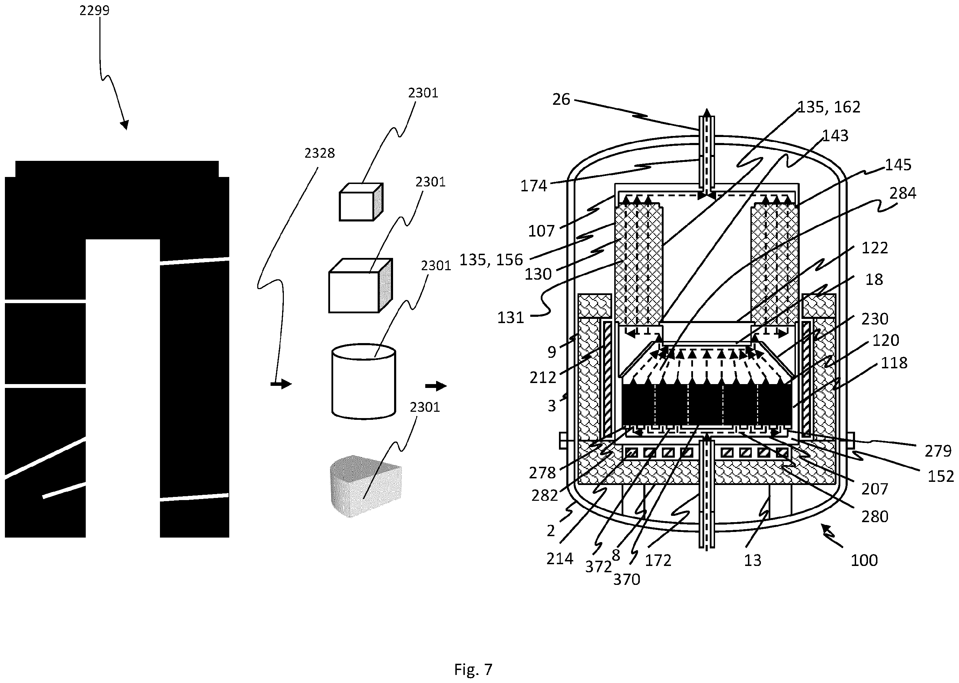

Fig. 7 shows the entire CVD SiC structure 2299 and a step of raw sawing 2328 the CVD SiC structure 2299. The raw sawing 2328 causes forming of SiC pieces 2301 in defined shapes, wherein the defined shapes are such that more than 80% (vol.) and preferably more than 90% (vol.) or highly preferably more than 95% (vol.) of a receiving space of a PVT reactor can be filled with one or multiple SiC pieces 2301, wherein each of the SiC pieces have a volume of more than 1cm×1cm×1cm and preferably of more than 2cmx1cmx1cm and highly preferably of more than 2cm×2cm×1cm.

The source material 120 is schematically divided in different pieces by "white doted lines" indicating the SiC pieces 2301. The SiC pieces 2301 can be crack-free but do not have to be crack-free.

Thus, one entire CVD SiC structure 2299 can be divided in crack-free SiC pieces 2300 and not-crack-free SiC pieces 2301, wherein the crack-free SiC pieces 2300 can be used for the production of SiC devices, like carrier wafers 2322, and the not-crack-free SiC pieces 2301 can be used as high-density source material for the production of monocrystalline SiC, in particular in a PVT reactor.

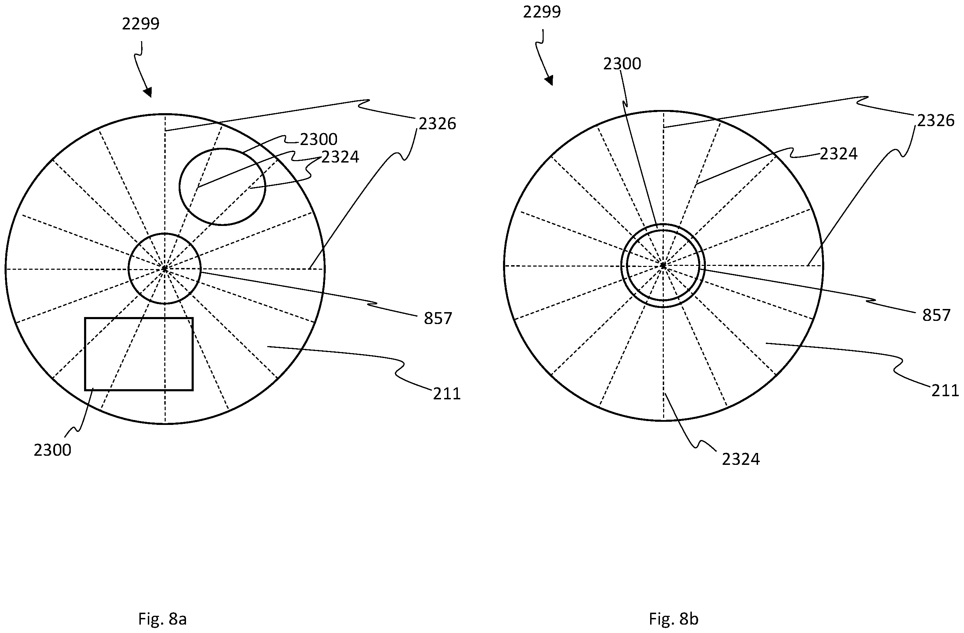

Fig. 8a and 8b schematically show positions of crack-free SiC pieces inside the entire CVD SiC structure 2299.

According to fig. 8a the pieces 2300 are arranged in the crust 211 of the CVD SiC structure 2299. Thus, the majority of grain orientations is aligned in an angle of less than 90° and preferably in an angle of less than 100°.

Reference number 2326 indicates schematically corners of a first "quarter". Thus, it is possible to virtually divide the CVD SiC structure 2299 in four quarters. In case the grain orientation of a SiC piece 2300 is less than 90° the SiC piece 2300 was preferably removed from one quarter.

Fig. 8b shows that the majority of grain orientations is aligned in an angle of more than 90° and preferably in an angle of more than 180° and most preferably in an angle of more than 270°.

**List of reference numbers**

| | | | |
|---|---|---|---|
| 18 | seed wafer | 213 | Sight glass |
| 100 | furnace apparatus | 240 | furnace housing inner surface |
| 102 | furnace unit | 242 | furnace housing outer surface |
| 104 | furnace volume | 850 | manufacturing device or CVD unit or CVD reactor respectively SiC production reactor, in particular SiC PVT source material production reactor |
| 106 | crucible unit | | |
| 107 | filter lid or crucible lid | | |
| 108 | furnace housing | | |
| 110 | crucible housing | 851 | first feeding device respectively first feed-medium source |
| 112 | crucible housing outer surface | | |
| 114 | crucible housing inner surface | 852 | second feeding device respectively second feed-medium source |
| 116 | crucible volume | 853 | third feeding device respectively third feed-medium source respectively carrier gas feed-medium source |
| 117 | bottom surface of receiving space | | |
| 118 | receiving space | | |
| 120 | source material | 854 | mixing device |
| 122 | seed holder unit | 855 | evaporator device |
| 123 | diameter of seed holder unit | 856 | process chamber |
| 124 | heating unit | 857 | SiC growth substrate |
| 202 | Upper housing | 858 | temperature measuring device or temperature control unit |
| 203 | Cross member | | |
| 206a | first electrode | 859 | Energy source, especially power supply |
| 206b | second electrode | | |
| 208 | Chuck | 859a | first power connection |
| 209 | Temperature measurement path | 859b | second power connection |
| 211 | SiC crust / SiC solid | | |
| 860 | Pressure maintaining device or | 2300 | crack-free SiC piece |
| | pressure control unit | 2301 | SiC piece possibly with cracks |
| 861 | outer surface of SiC growth substrate or SiC growth surface | 2302 | first plane |
| 862 | base plate | 2304 | second plane |
| 864 | bell jar | 2305 | crack |
| 864a | side wall section | 2306 | first direction |
| 864b | top wall section | 2308 | second direction |
| 865 | metal surface | 2314 | crack-free sub piece / predefined piece / wafer |
| 866 | gas inlet unit | 2316 | surface of wafer / processed surface |
| 867 | reflective coating | 2317 | monocrystalline SiC crystal |
| 868 | cooling element | 2318 | monocrystalline SiC wafer |
| 870 | active cooling element | 2320 | composite substrate |
| 873 | fluid forwarding unit | 2322 | carrier wafer |
| 892 | cooling fluid temperature sensor | 2324 | grain orientation |
| 966 | reaction space | 2326 | corners of quarter |
| 1160 | Feed gas mixture | 2328 | rough sawing |
| 2040 | Lower housing | 2330 | wafer slicing |
| 2120 | Vent gas | 2332 | wafer lapping |
| 2140 | Feed gas inlet | 2334 | removing thin layer of mono SiC |
| 2200 | main body | 2336 | wafer polishing |
| | | 2338 | wafer bonding |
| 2299 | CVD SiC with physical structure | | |

## Claims

1. Method for producing at least one crack-free SiC piece at least comprising the steps:
Providing a CVD reactor (850), wherein the CVD reactor (850) comprises at least one SiC growth substrate (857), wherein the at least one SiC growth substrate (857) comprises
a main body (2200),
a first power connection (859a) and
a second power connection (859b),
wherein the main body (2200) has a main body length (ML), wherein the main body length (ML) extends between the first power connection (859a) and the second power connection (859b),
wherein the first power connection (859a) is configured to conduct power into the main body (2200) for heating the main body (2200) and wherein the second power connection (859b) is configured to conduct electric power conducted via the first power connection (859a) into the main body (2200) out of the main body (2200),
wherein the main body (2200) forms a physical structure,
wherein the physical structure forms a deposition surface (861) for deposition of SiC,
Growing a SiC solid (211) by depositing SiC on the physical structure in the CVD reactor (850),
wherein the at least one crack-free SiC piece (2300) is part of the SiC solid (211),
wherein the deposited SiC has a minimal thickness of at least 1cm,
wherein the at least one SiC piece (2300) is formed between a first plane (2302) and a second plane (2304), wherein the first plane (2302) is perpendicular to the main body length (ML) and wherein the second plane (2304) is perpendicular to the main body length (ML), wherein the distance (D) between the first plane (2302) and the second plane (2304) is at least 1% and preferably at least 2% and highly preferably at least 5% of the main body length (ML),
the deposited SiC is polycrystalline SiC, wherein the deposited SiC forms volume sections with different crystal structures, wherein a 3C crystal structure is predominantly (mass and/or volume) formed, wherein the volume and/or mass of SiC formed in the 3C crystal structure comprises more than 50% (volume and/or mass) of the deposited SiC,
Removing the at least one crack-free SiC piece (2300) from the SiC solid (211),
wherein the at least one crack-free SiC piece (2300) has a cross-sectional size of at least 4cm² and preferably of at least 8cm² and highly preferably of at least 12cm² and a thickness of at least 0,1cm and preferably of at least 1cm and highly preferably of at least 2cm, and/or
wherein the volume (V) of the at least one crack-free SiC piece (2300) is more than 2cm³ and preferably more than 4cm³ and most preferably more than 8cm³.

2. Method according to claim 1,
**characterized in that**
the first direction (2306) is parallel to the main body length (ML) or coaxial to the main body length (ML) or aligned in an angle of less than 50° with respect to the main body length (ML).

3. Method according to claim 1,
**characterized in that**
the first direction (2306) is aligned in an angle between 120° and 60° with respect to the main body length (ML).

4. Method according to claim 2 or 3,
**characterized in that**
the at least one crack-free SiC piece (2300) is formed in a distance to the physical structure, wherein the physical structure comprises less than 5% (mass) SiC, wherein the physical structure comprises more than 90% (mass) of graphite, tungsten or a carbon-fiber-composite (CFC) material.

5. Method according to claims 2 or 3,
**characterized in that**
the at least one crack-free SiC piece (2300) is formed at least partially as part of the physical structure, wherein the physical structure comprises more than 90% (mass) SiC, in particular polycrystalline SiC.

6. Method according to claims 1 to 5,
**characterized by**
the step of controlling cooling of the deposited SiC and the physical structure, wherein current flow through the physical structure is reduced in a defined manner, in particular over a defined time, in particular of more than 1h or preferably of more than 2h or particular preferably of more than 3h or most preferably of more than 4h.

7. Method according to claims 1 to 6,
**characterized in that**
the deposited SiC comprises less than 2000ppba nitrogen, in particular less than 100ppba nitrogen, wherein the deposited SiC and/or the physical structure has impurities of less than 10ppm (weight) of the substance N and of less than 1000 ppb (weight), in particular of less than 500 ppb (weight), of each of the substances B, Al, P, Ti, V, Fe, Ni.

8. Method according to claims 1 to 7,
**characterized in that**
feeding nitrogen into the CVD reactor (850) for doping the SiC during depositing.

9. Method for the production of multiple crack-free workpieces,
at least comprising a method according to any of claims 1 to 8, and the step of Dividing the at least one crack-free SiC piece (2300) in multiple predetermined pieces, wherein the dividing step comprises
cutting the defined volume section with at least one wire saw
or
weakening the structure of the defined volume with laser radiation and thereby generating a defined laser-split-plane and introducing an external force to propagate a crack along the defined laser-split-plane
or
implanting ions into the structure of the defined volume and thereby generating a defined ion-split-plane and increasing the pressure inside the defined volume by increasing the volume of the implanted ions, in particular by heating the defined volume, to propagate a crack along the defined ion-split-plane

10. Method according to claim 9,
**characterized in that**
the predetermined pieces (2314) are wafers, wherein each wafer has a height of more than 200µm, in particular of more than 250µm and preferably of up to 1000µm or of more than 1000µm and/or wherein a diameter of the main body (2200) has a minimum length of 100mm and preferably a minimum length of 150mm and particular preferably a minimum length of 250mm and most preferably a minimum or maximum length of 300mm.

11. Method for the production of a composite substrate (2320),
at least comprising a method according to claim 10 and the steps:
processing at least one surface (2316) of the wafer, in particular grinding and/or lapping and/or polishing, to generate a processed surface having at least one defined surface property
and
bonding a monocrystalline SiC wafer (2318) to the processed surface.

12. Carrier wafer (2322) produced according to claim 10,
**characterized in that**
the carrier wafer (2322) has a diameter of at least 7,5cm
the carrier wafer (2322) has a height of at least 200µm,
the carrier wafer (2322) is predominantly formed by a 3C crystal structure,
wherein the 3C crystal structure is Nitrogen doped, in particular more than 2000ppba nitrogen, and comprises an electric resistivity < 0.01 Ohm cm.

13. Crack-free SiC piece (2300) produced according to any of claims 1 to 8,
**characterized in that**
the crack-free SiC piece (2300) is predominantly formed by a 3C crystal structure,
wherein the dimensions of the crack-free SiC piece (2300) are at least 2cm × 2cm × 1cm
wherein the density of the crack-free SiC piece is more than 3 g/cm3.

14. Method for producing predefined PVT source material pieces for filling a source material receiving space of PVT reactor, wherein the PVT source material is SiC, wherein the SiC predominantly has a 3C crystal structure
at least comprising the steps:
Providing a CVD reactor (850), wherein the CVD reactor (850) comprises at least one SiC growth substrate (857), wherein the at least one SiC growth substrate (857) comprises a main body,
a first power connection (859a) and
a second power connection (859b),
wherein the main body has a main body length, wherein the main body length extends between the first power connection (859a) and the second power connection (859b),
wherein the first power connection is configured to conduct power into the main body for heating the main body and wherein the second power connection is configured to conduct electric power conducted via the first power connection into the main body out of the main body,
wherein the main body forms a physical structure,
wherein the physical structure forms a deposition surface for deposition of SiC,
Growing a SiC solid by depositing SiC on the physical structure in the CVD reactor,
wherein the at least one SiC piece is part of the SiC solid,
wherein the deposited SiC has a minimal thickness of at least 1cm,
Removing the at least one SiC piece from the SiC solid,
wherein the at least one SiC piece has a cross-sectional size of at least 4cm² and preferably of at least 8cm² and highly preferably of at least 12cm² and a thickness of at least 0,1cm and
preferably of at least 1cm and highly preferably of at least 2cm,
wherein the at least one SiC piece has a shape configured to fill at least 75% of a volume of a defined source material receiving space of a defined PVT reactor
or
wherein the at least one SiC piece has a shape configured to fill together with at least one further SiC piece having the same shape at least 75% of a volume of a defined source material receiving space of a defined PVT reactor.

15. Method for producing SiC material,
at least comprising the steps:
Providing at least one furnace apparatus (100) for growing SiC crystals,
comprising
a furnace unit (102),
wherein the furnace unit (102) comprises a furnace housing (108) with an outer surface (242) and an inner surface (240),
at least one crucible unit (106)
wherein the crucible unit (106) is arranged inside the furnace housing (108),
wherein the crucible unit (106) comprises a crucible housing (110),
wherein the housing (110) has an outer surface (112) and an inner surface (114), wherein the inner surface (114) at least partially defines a crucible volume (116),
wherein a receiving space (118) for receiving a solid SiC source material (120) is arranged or formed inside the crucible volume (116),
wherein a seed holder unit (122) for holding a defined seed wafer (18) is arranged inside the crucible volume (116),
wherein the furnace housing inner wall (240) and the crucible housing outer wall (112) define a furnace volume (104),
at least one heating unit (124) for heating the source material (120),
wherein the receiving space (118) for receiving the source material (120) is at least in parts arranged below the seed holder unit (122),
Arranging source material in the receiving space within the crucible housing,
wherein the source material is made of exactly one SiC piece (2301) according to claim 14, wherein the source material fills at least 75% and preferably at least 90% and highly preferably at least 95% and most preferably at least 98% of a volume of the receiving space (118)
or
wherein the source material is made of multiple SiC pieces (2301) according to claim 14, wherein at least a plurality and preferably all of the multiple SiC pieces have the same shape, wherein the source material fills at least 75% and preferably at least 90% and highly preferably at least 95% and most preferably at least 98% of a volume of the receiving space (118)
Heating the source material,
Feeding a carrier gas into the crucible housing.
